# EUROPEAN PATENT APPLICATION

(11) **EP 4 617 698 A1**
(43) Date of publication of application: **17.09.2025**
(21) Application number: 25162991.1
(22) Date of filing: 11.03.2025
(51) Int. Cl.: G01R 33/26

(54) **OPTICAL MAGNETOMETER AND METHOD OF MAGNETOMETRY**

(30) Priority: 13.03.2024 US 202463564635 P; 13.03.2024 US 202463564843 P; 28.02.2025 US 202519066402
(71) Applicant: II-VI Delaware, Inc., Wilmington, DE 19890 (US)
(72) Inventor: CHEN, Young-Kai, Wilmington, 19890 (US); TATARCZAK, Anna, Wilmington, 19890 (US); KOCOT, Chris, Wilmington, 19890 (US); TANNER, Charles, Wilmington, 19890 (US); BARBAROSSA, Giovanni, Wilmington, 19890 (US)
(74) Representative: Schmidt, Christian

(57) **Abstract**

A magnetometer includes a vertical-external cavity light-emitting laser (VECSEL) structure, a resonant atomic medium, and a fluoresced light detector. The VECSEL structure includes an upper mirror, a lower mirror, a vertical cavity between the upper mirror and the lower mirror, and an active region configured to develop a VECSEL light between the upper mirror and the lower mirror. The resonant atomic medium is positioned between the upper mirror and the lower mirror of the VECSEL structure and includes lattice vacancies that fluoresce light when excited by an excitation light having an excitation wavelength. Characteristics of the fluoresced light are dependent upon a magnetic field applied to the resonant atomic medium. The fluoresced light detector is configured to generate a fluoresced measurement signal indicative of the fluoresced light and the magnetic field applied to the resonant atomic medium.

## Description

### CROSS-REFERENCE TO RELATED APPLICATIONS

The present application claims benefit of and priority to U.S. Provisional Application No. 63/564,843, filed March 13, 2024 and claims benefit of and priority to U.S. Provisional Application No. 63/564,635, filed March 13, 2024, the contents of which are hereby incorporated herein by reference in their entirety.

### TECHNICAL FIELD

Aspects of the present disclosure are related to magnetometry, and in particularly to optical magnetometers.

### BACKGROUND

Conventional magnetometers are often limited by size, complexity, and sensitivity.

### BRIEF SUMMARY OF THE DISCLOSURE

Shown in and/or described in connection with at least one of the figures, and set forth more completely in the claims are optical magnetometers that utilize vertical external cavity surface emitting lasers (VECSEL) structures and resonant atomic medium to measure magnetic fields.

These and other advantages, aspects, and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 depicts a magnetometer with an electrically-pumped vertical external cavity surface emitting laser (VECSEL) structure and resonant atomic medium in accordance with various aspects of the present disclosure.
FIG. 2 depicts a magnetometer with an electrically-pumped VECSEL structure and resonant atomic medium in accordance with various aspects of the present disclosure.
FIG. 3A depicts a first pump configuration of a magnetometer with an electrically-pumped VECSEL structure in accordance with various aspects of the present disclosure.
FIG. 3B depicts a second pump configuration of a magnetometer with an optically-pumped VECSEL structure in accordance with various aspects of the present disclosure.

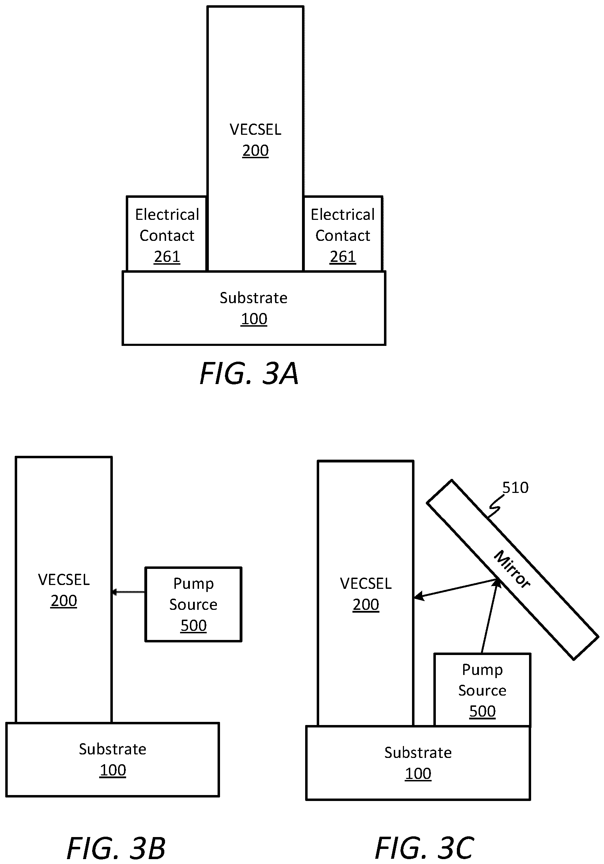

FIG. 3B depicts a third pump configuration of a magnetometer with an optically-pumped VECSEL structure in accordance with various aspects of the present disclosure.

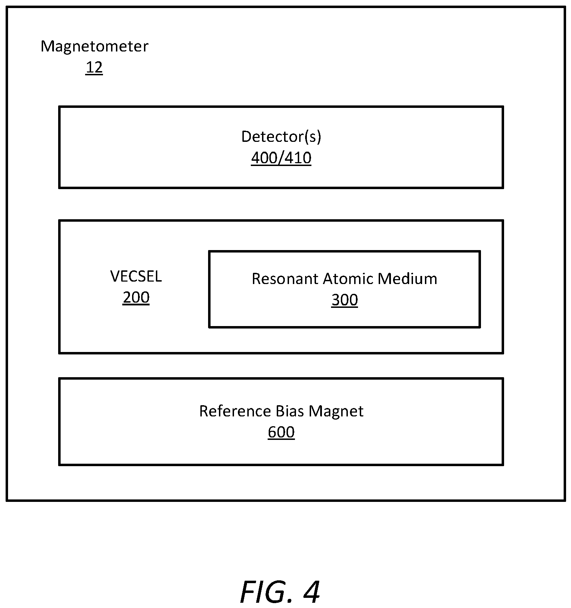

FIG. 4 depicts a magnetometer with a reference bias magnet in accordance with various aspects of the present disclosure.

### DESCRIPTION

The following discussion provides various examples of optical magnetometers and associated methods of operating optical magnetometers. Such magnetometers may utilize vertical external cavity surface emitting lasers (VECSEL) structures and resonant atomic medium to measure magnetic fields. Such examples are non-limiting, and the scope of the appended claims should not be limited to the particular examples disclosed. In the following discussion, the terms "example" and "e.g." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}.

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Aspects of the present disclosure are directed to magnetometry, optical magnetometers, and methods of operating optical magnetometers. In various embodiments, an optical magnetometer may comprise a vertical external cavity surface emitting laser (VECSEL) structure and diamond or silicon carbide with color centers used as a resonant atomic medium. The resonant atomic medium may impart the VECSEL structure with magnetic field detection capabilities. By incorporating the resonant atomic medium (*e.g.,* diamond, silicon carbide, *etc.*) inside the cavity of the VECSEL structure, a more compact, sensitive, and/or efficient magnetometer may be obtained in comparison to conventional techniques.

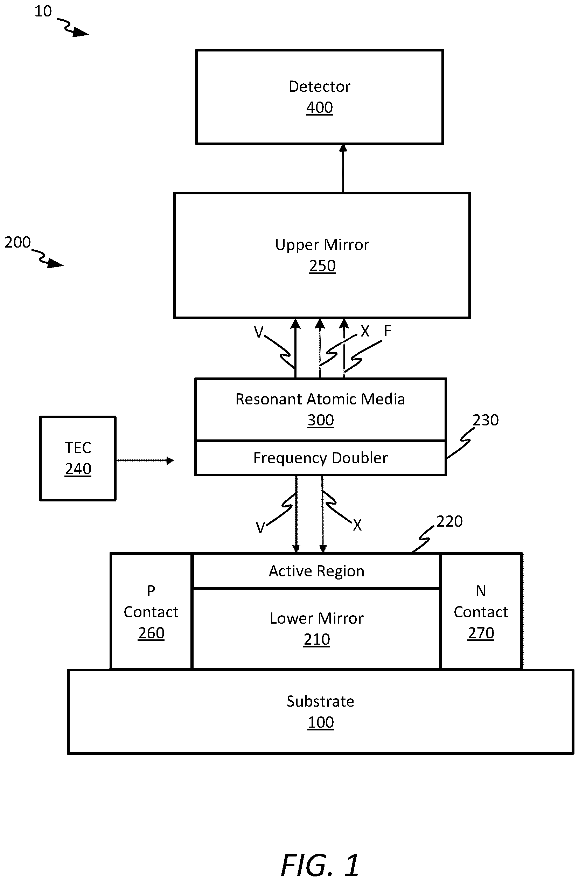

Referring now to FIG. 1, an example optical magnetometer 10 is shown. The optical magnetometer 10 may include a semiconductor substrate 100, a VECSEL structure 200, a resonant atomic medium 300, and a fluoresced light detector 400. The VECSEL structure 200 may include a bottom distributed Bragg reflector (DBR) stack or mirror 210, an active region 220, a frequency doubler 230, a thermoelectric cooler (TEC) 240, a p contact 260, and an n contact 270, which may be formed on the semiconductor substrate 100. The VECSEL structure 200 may further include an upper volume Bragg's grating (VBG) or mirror 250. The upper mirror 250 may be spaced apart from the VECSEL structure stack formed on semiconductor substrate 100. While a single VECSEL structure 200 is depicted, the optical magnetometer 10 in some embodiments may include an array of VECSEL structures. Further, other embodiments may utilize a vertical cavity surface emitting laser (VCSEL) structure, distributed-feedback (DFB) laser, and semiconductor optical amplifier (SOA)-in-cavity for direct pumping of structure.

The active region 220 may comprise quantum wells, quantum dots, and/or quantum dashes which may be electrically pumped via the p contact 260 and the n contact 270. Such electrical pumping of the VECSEL structure 200 may cause the active region 220 to emit light and develop VECSEL light *V* between the lower mirror 210 and the upper mirror 250 having a first or VECSEL wavelength. In some embodiments, the electrical pumping may develop the VECSEL light *V* at near-infrared (NIR) wavelengths (*e.g.,* 1064 nanometers (nm)). In order to improve the magnetometer sensitivity, the VECSEL light *V* may be continuous, frequency modulated, and/or polarized.

The frequency doubler 230 may be positioned in the vertical cavity between the lower mirror 210 and the upper mirror 250 to double the frequency (or halve the wavelength) of the VECSEL light Vto an excitation wavelength (*e.g*., 532 nm) suitable for exciting vacancies of the resonant atomic medium 300 as described below. In particular, the frequency doubler 230 may comprise a non-linear crystal such as lithium niobate that develops an excitation light *X* for the resonant atomic medium 300 by doubling the frequency of the VECSEL light *V.* For example, the non-linear crystal may generate the excitation light *X* through the second harmonic for the NIR VECSEL light *V.*

The thermoelectric cooler (TEC) 240 may provide the frequency doubler 230 with temperature stabilization to assure wavelength stability. In particular, the TEC 240 may transport heat away from the non-linear crystal of the frequency doubler 230 in order to maintain an ideal temperature. The TEC 240 may achieve such heat transport through the Peltier Effect, which enables the transfer of heat energy between two materials when an electric current passes through. A TEC 240 may comprise a controller that produces and maintains the electric current in order to achieve the desired temperature. By controlling the direction of the current flow, the TEC controller may cause heat to transfer to or from the non-linear crystal of the frequency doubler 230 in order to maintain the non-linear crystal at a desired temperature.

The resonant atomic medium 300 may comprise diamond or silicon carbide (SiC) embedded with color centers, which form nitrogen-vacancies that fluoresce in response to excitation light *X* having a certain excitation wavelength. Moreover, the fluorescence of such vacancies may vary based on a magnetic field applied to the resonant atomic medium 300. In particular, under an applied magnetic field, atomic spins within the vacancy centers may be deflected and may lead to energy shifts observable through changes in absorption or photoluminescence. These energy shifts correspond to alterations in fluoresced light *F* and may be monitored by the fluoresced light detector 400 of the magnetometer 10. Through such detected energy shifts, characteristics of the magnetic field may be determined.

To this end, the resonant atomic medium 300 may be positioned in the vertical cavity of the VECSEL structure 200 at, for example, the maximum optical field. Such placement may enable a highly efficient excitation of the vacancy centers in the resonant atomic medium 300. Moreover, such placement in the vertical cavity may require less power from the VECSEL structure 200 than for configurations in which the resonant atomic medium 300 is positioned outside the cavity. The resonant atomic medium 300 may be stacked on or separated from the frequency doubler 230. In some embodiments, walls of the VECSEL cavity may be implanted with the resonant atomic medium 300.

The resonant atomic medium 300 may comprise diamond. The diamond may be embedded with nitrogen-vacancy (NV) centers. The NV centers may provide point defects or lattice vacancies in the diamond lattice structure that exhibit spin-dependent photoluminescence in the presence of a magnetic field. In particular, the NV centers may fluoresce red light *F* (*e.g.,* light with a wavelength of 750 nm) when excited by visible green light *X* (*e.g.*, light with a wavelength of 532 nm).

In some embodiments, the resonant atomic medium 300 may comprise silicon carbide (SiC). The silicon carbide may be similarly embedded with color centers from silicon-vacancies or other dopants. These color centers in the SiC lattice structure may exhibit spin-dependent photoluminescence in the presence of a magnetic field. In particular, the silicon-vacancy color centers may fluoresce light *F* with a wavelength of 919 nm when excited by visible red light *X* (*e.g.*, light with a wavelength of 785 nm).

While diamond and silicon carbide are presented as examples, other crystalline structures may be embedded with color centers and used as the resonant atomic medium. For such embodiments, the VECSEL structure 200 may be configured to develop excitation light *X* at a suitable wavelength to excite photoluminescence of the embedded color centers.

In the embodiment of FIG. 1, the lower mirror 210 and the upper mirror 250 reflect the wavelength of the VECSEL light *V.* Moreover, the upper mirror 250 is configured to be transparent to the wavelength of the fluoresced light *F*, thus permitting the fluoresced light detector 400 to receive and detect the fluoresced light *F.* The upper mirror 250 may be further configured to absorb or reflect the wavelength of the excitation light *X*, thus effectively filtering the excitation light *X* from the fluoresced light detector 400. However, in some embodiments, the upper mirror 250 may be transparent or translucent to the wavelength of the fluoresced light detector 400. In such embodiments, the fluoresced light detector 400 may be designed with a narrow wavelength detection range and effectively filter the excitation light *X* from the fluoresced light *F* and/or may be designed to otherwise extract or detect the fluoresced light *F* in the presence of the excitation light *X.*

As depicted the fluoresced light detector 400 may be placed above the upper mirror 250 of the VECSEL structure 200. The fluoresced light detector 400 may be designed to detect a wavelength range of interest (*e.g*., a wavelength range including the fluoresced light *F*) and generate a fluoresced measurement signal indicative of the detected light in the wavelength range of interest and the magnetic field effects upon the fluoresced light *F.* For example, the fluoresced light detector 400 may be configured to detect fluoresced light *F in* a wavelength range of 600-800 nm when used with a diamond resonant atomic medium that fluoresces red light of 750 nm. The fluoresced light detector 400 and/or magnetometer 10 may include additional filters that permit a narrow range of light to reach the detecting elements (*e.g*., photodiode) of the fluoresced light detector 400.

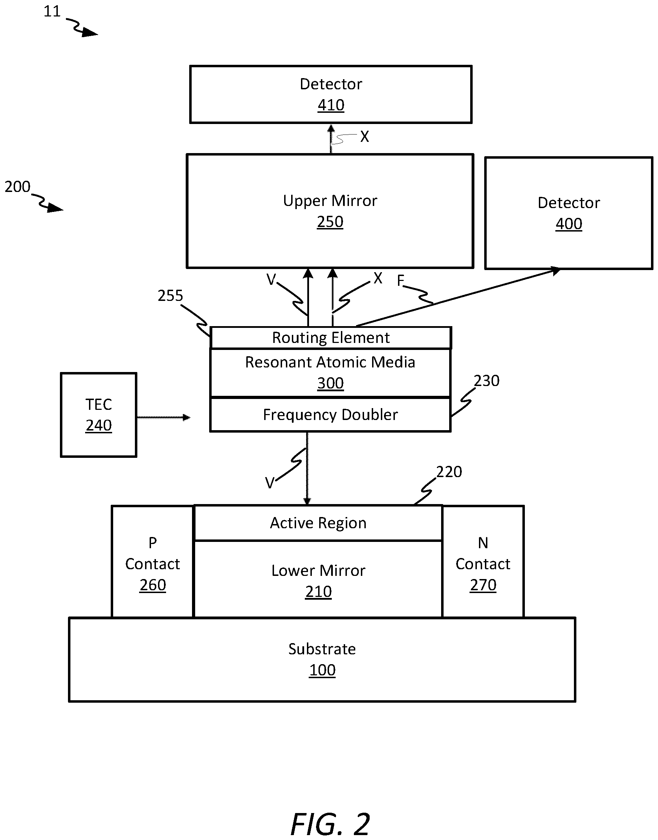

Referring now to FIG. 2, an optical magnetometer 11 is shown. The optical magnetometer 11 may be implemented in a manner similar to the optical magnetometer 10 of FIG. 1. However, the fluoresced light detector 400 of the optical magnetometer 11 is positioned laterally from the VECSEL cavity and includes a routing element 255 between the lower mirror 210 and an upper mirror 251 which routes or directs the fluoresced light *F* to the fluoresced light detector 400. For example, the routing element 255 may comprise a grating and/or meta optical surface on or over the resonant atomic medium 300. Such grating and/or meta optical surface may provide different output angles for different wavelengths. For example, the grating and/or meta optical surface may provide a 180° angle for the VECSEL light *V* and the excitation light *X* and a higher angle for the excitation light *X*. In this manner, the grating and/or meta optics may permit the VECSEL light *V* and excitation light *X* to pass straight through, but may angle or route the fluoresced light *F* to the fluoresced light detector 400.

Due to such routing of the fluoresced light *F*, the upper mirror 251 of the magnetometer 11 may be implemented without regard to the fluoresced light *F* since the fluoresced light *F* is directed to the fluoresced light detector 400 without passing through the upper mirror 251. Similar to the upper mirror 250, the upper mirror 251 may be implemented to reflect the wavelength of the VECSEL light *V.* But, unlike the upper mirror 250, the upper mirror 251 may be transparent to the wavelength of the excitation light *X.*

The magnetometer 11 may include an excitation light detector 410 above the upper mirror 251 to receive the excitation light *X* that passes through the upper mirror 250. As such, the excitation light detector 410 may generate an excitation measurement signal indicative of the received excitation light *X.* The excitation measurement signal may further aid in determining magnetic field measurements from the fluoresced measurement signal generated by the fluoresced light detector 400.

Similar to the fluoresced light detector 400, the detector 410 may be designed to detect a wavelength range of interest (*e.g*., a wavelength range including the excitation light *X*) and generate an excitation measurement signal indicative of the detected light in the wavelength range of interest. For example, the excitation light detector 410 may be configured to detect excitation light *X* in a wavelength range of 400-600 nm when used with a diamond resonant atomic medium that is excited with green light of 532 nm. The excitation light detector 410 and/or magnetometer 11 may include additional filters that permit a narrow range of light to reach the detecting elements (*e.g*., photodiode) of the excitation light detector 410.

Referring now to FIGS. 3A-3C, various pump configurations for magnetometers are shown. In particular, FIG. 3A depicts a magnetometer with an electrically-pumped VECSEL structure 200 suitable for the magnetometers 10, 11 of FIGS. 1 and 2. As shown, the VECSEL structure 200 may include one or more electrical contacts 261 via which the VECSEL active region 220 may be electrically-pumped.

FIGS. 3B and 3C depict pump configurations in which the VECSEL structure 200 is optically-pumped by a pump source 500 external to the VECSEL cavity. In the configuration of FIG. 3B, the pump source 500 is positioned laterally from the VECSEL cavity. In such embodiments, the pump source 500 directs light into the VECSEL cavity to develop the VECSEL light *V.* In the configuration of FIG. 3C, the pump source 500 may be positioned or formed on the substrate 100. The pump source 500 may direct light toward an optical element 510 such as a mirror, which reflects or directs the pump source light to the VECSEL cavity. In some embodiments, the pump source 500 may provide light having the excitation wavelength of the resonant atomic medium 300. In such embodiments, the VECSEL may lack the frequency doubler 230 and the VECSEL light *V* and the excitation light *X* may be the same.

Referring now to FIG. 4, a magnetometer 12 comprising a reference bias magnet 600 is shown. The magnetometer 12 may comprise the VECSEL structure 200 with resonant atomic medium 300, one or more detectors 400 and/or 410, and a reference bias magnet 600. The VECSEL structure 200, resonant atomic medium 400, and detectors 400, 410 may be implemented in a manner similar to components of the magnetometers of FIGS. 1-3C. The reference bias magnet 600 may be positioned beneath the VECSEL structure 200. The reference bias magnet 600 may apply a reference bias magnetic field to the resonant atomic medium 300. Such reference bias magnetic field may serve as a reference or baseline magnetic vector used for vectorization of the magnetometer output. Moreover, the magnetometers of FIG. 1-3C may similarly include a reference bias magnet 600.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.

## Claims

1. A magnetometer, comprising:
a vertical external cavity surface emitting laser (VECSEL) structure comprising an upper mirror, a lower mirror, a vertical cavity between the upper mirror and the lower mirror, and an active region configured to develop a VECSEL light between the upper mirror and the lower mirror;
a resonant atomic medium between the upper mirror and the lower mirror of the VECSEL structure, wherein the resonant atomic medium comprises color centers or other dopants that form vacancies that fluoresce light when excited by an excitation light having an excitation wavelength, and wherein characteristics of the fluoresced light are dependent upon a magnetic field applied to the resonant atomic medium; and
a fluoresced light detector configured to generate a fluoresced measurement signal indicative of the fluoresced light and the magnetic field applied to the resonant atomic medium.

2. The magnetometer of claim 1, wherein:
the VECSEL structure comprises a frequency doubler between the upper mirror and the lower mirror; and
the frequency doubler is configured to develop the excitation light from the VECSEL light by doubling a frequency of the VECSEL light.

3. The magnetometer of claim 2, wherein the VECSEL structure comprises a plurality of electrical contacts that electrically pump the VECSEL structure to develop the VECSEL light at twice the excitation wavelength.

4. The magnetometer of claim 2, comprising a pump source external to the VECSEL structure that optically pumps the VECSEL structure with light at twice the excitation wavelength.

5. The magnetometer of claim 1, comprising a pump source external to the VECSEL structure that optically pumps the VECSEL structure with light at the excitation wavelength.

6. The magnetometer of claim 1, wherein:
the resonant atomic medium comprises silicon carbide; and
the silicon carbide is embedded with color centers or other dopants that form silicon-vacancies.

7. The magnetometer of claim 6, wherein:
the excitation light has a wavelength of 785 nanometers (nm); and
the fluoresced light has a wavelength of 919 nm.

8. The magnetometer of claim 1, wherein:
the resonant atomic medium comprises diamond; and
the diamond is embedded with color centers that form nitrogen-vacancy (NV) centers.

9. The magnetometer of claim 8, wherein:
the excitation light has a green light wavelength; and
the fluoresced light has a red light wavelength.

10. The magnetometer of claim 1, wherein:
the upper mirror is configured to reflect the VECSEL light and permit passage of the fluoresced light; and
the fluoresced light detector is positioned over the upper mirror.

11. The magnetometer of claim 1, comprising:
a routing element that angles the fluoresced light toward the fluoresced light detector; and
wherein the fluoresced light detector is positioned laterally from the vertical cavity of the VECSEL structure.

12. The magnetometer of claim 1, comprising a reference bias magnet beneath the VECSEL structure.

13. The magnetometer of claim 1, comprising an excitation light detector configured to receive the excitation light and generate an excitation measurement signal.

14. A method of a magnetometer, the method comprising:
developing an excitation light in a vertical cavity of a vertical external cavity surface emitting laser (VECSEL) structure;
exciting, with the excitation light, lattice vacancies of a resonant atomic medium in the vertical cavity of the VECSEL structure;
in response to exciting the lattice vacancies, fluorescing a fluoresced light having characteristics dependent upon a magnetic field applied to the resonant atomic medium; and
generating, with a fluoresced light detector, a fluoresced measurement signal indicative of the fluoresced light and the magnetic field applied to the resonant atomic medium.

15. The method of claim 14, comprising generating the excitation light by doubling a VECSEL light developed between an upper mirror and a lower mirror of the VECSEL structure.

16. The method of claim 15, comprising electrically-pumping the VECSEL structure to develop the VECSEL light.

17. The method of claim 15, comprising optically-pumping the VECSEL structure with a pump source positioned laterally from a vertical cavity of the VECSEL structure.

18. The method of claim 14, wherein exciting the lattice vacancies comprises exciting nitrogen-vacancy (NV) centers embedded in diamond.

19. The method of claim 14, wherein exciting the lattice vacancies comprises exciting silicon vacancies embedded in silicon carbide.

20. The method of claim 14, comprising applying a reference bias magnetic field to the resonant atomic medium.
